# EUROPEAN PATENT SPECIFICATION

(11) **EP 0 808 230 B1**
(45) Date of publication and mention of the grant of the patent: **26.04.2000**
(21) Application number: 96902098.1
(22) Date of filing: 11.01.1996
(51) Int. Cl.: B24B 37/04

(54) **CHEMICAL-MECHANICAL POLISHING OF THIN MATERIALS USING A PULSE POLISHING TECHNIQUE**
CHEMISCH-MECHANISCHES POLIEREN VON DÜNNEN MATERIALEN MITTELS EINES IMPULS POLIERVERFAHREN
POLISSAGE CHIMIQUE-MECANIQUE D'ARTICLES MINCES FAISANT APPEL A UNE TECHNIQUE DE POLISSAGE PULSE

(30) Priority: 06.02.1995 US 383737
(43) Date of publication of application: 26.11.1997
(73) Proprietor: ADVANCED MICRO DEVICES INC., Sunnyvale, California 94088-3453 (US)
(72) Inventor: SALUGSUGAN, Isidore, Fremont, CA 94555 (US)
(74) Representative: BROOKES & MARTIN
(86) International application number: PCT/US96/00151
(87) International publication number: WO 96/24466

(56) References cited:
- EP-A- 0 504 887
- EP-A- 0 589 434
- US-A- 4 022 625
- US-A- 4 511 605
- US-A- 4 523 975
- US-A- 5 354 387
- PATENT ABSTRACTS OF JAPAN vol. 011, no. 397 (M-655), 25 December 1987 & JP,A,62 162464 (HITACHI LTD), 18 July 1987,

## Description

### Technical Field

The present invention relates a chemical-mechanical polishing method to effect a high removal rate of material and uniform planarization of a surface on a wafer during the manufacture of a semiconductor device. The invention has particularly application in rapidly planarizing thin films of dielectric material.

### Background Art

Semiconductor integrated circuits are manufactured by forming an array of separate dies on a common semiconductor wafer. During processing, the wafer is treated to form specified regions of insulating, conductive and semiconductor type materials. The ever increasing requirements for high density devices comprising wiring patterns with increasingly smaller distances between conductive lines, coupled with increasing economic pressures for reduced production time and increased throughout, pose a significant technological challenge. Conventionally, a wiring pattern comprising a dense array of conductive lines is formed by depositing a metal layer and etching to form a conductive pattern. A dielectric is then applied to the wiring pattern and planarization is effected as by chemical-mechanical polishing. However, it is extremely difficult to planarize layers with high removal rates of material, particularly with dense arrays of conductive lines separated by distances of less than 0.5 micron.

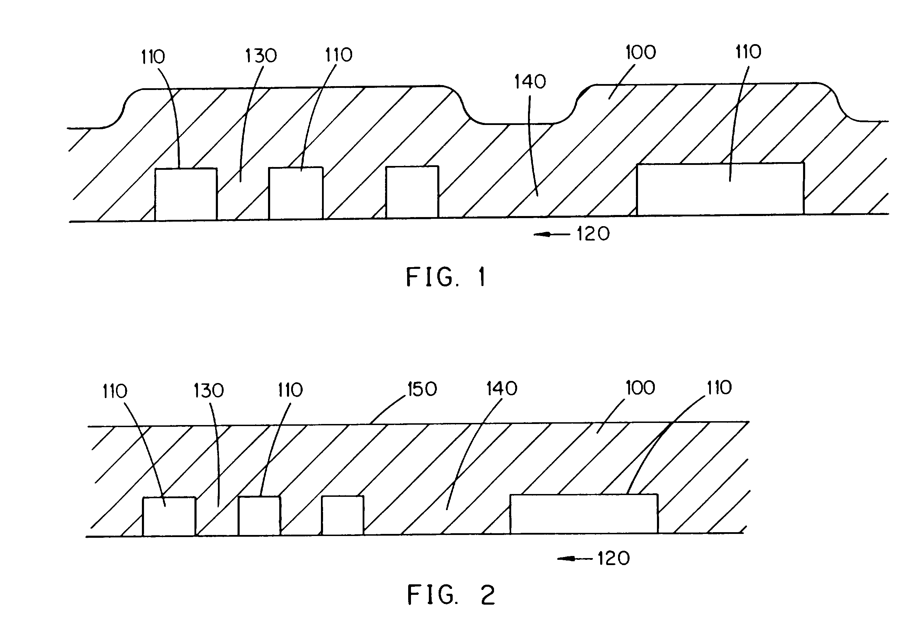

Chemical-mechanical polishing is a conventional technique employed to planarize a patterned insulating layer or a patterned metallic layer. For example, as shown in Fig. 1, during an initial processing stage for forming an integrated circuit, a pattern 110 is formed on layer 120 of, for example, an insulating material, a conductive material such as a metal, or a semiconductor substrate having an interwiring spacing 130 and trench 140. The object is to completely fill the interwiring spacing 130 and trench 140 with a subsequently deposited material 100 as, for example, an insulating material if pattern 110 is a conductive pattern. After layer 100 is deposited, it must be planarized to obtain a uniformly planarized surface 150 as shown in Fig. 2 wherein line numerals denote like components. Planarization is conventionally effected by plasma etching, or by a simplified faster and relatively inexpensive method known as chemicalmechanical planarization or polishing (CMP). CMP as defined in the preamble of claim 1 is a conventional technique as disclosed in, see for example, ***Salugsugan***, U.S. Patent No. 5,245,794; ***Beyer et al.***, U.S. Patent No. 4,944,836; ***Youmans,*** U.S. Patent No. 3,911,562. See also U.S. Patent No. 4,193,226 and 4,811,522 to ***Gill, Jr.*** and U.S. Patent No. 3,841,031 to ***Walsh*** which relate to CMP apparatus.

Basically, in employing a conventional CMP apparatus, wafers to be polished are mounted on polishing blocks which are placed on the CMP machine. A polishing pad is adapted to engage the wafers carried by the polishing blocks. A cleaning agent is dripped onto the pad continuously during the polishing operation while pressure is applied to the wafer.

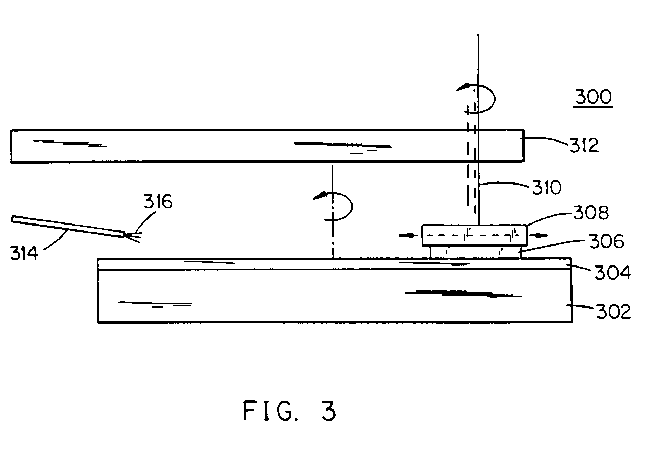

A typical CMP apparatus 300 is shown in Fig. 3 and comprises a rotatable polishing platen 302, polishing pad 304 mounted on platen 302, which are driven by microprocessor control motor (not shown) to spin at about 25 to about 50 RPM. Wafer 306 is mounted on the bottom of a rotatable polishing head 308 so that a major surface of wafer 306 to be polished is positionable to contact the underlying polish pad 304. Wafer 306 and polishing head 308 are attached to a vertical spindle 310 which is rotatably mounted in a lateral robotic arm 312 which rotates the polishing head 308 at about 15 to about 30 RPM in the same direction as platen 302 and radially positions the polishing head. Robotic arm 312 also vertically positions polishing head 308 to bring wafer 306 into contact with polishing head 304 and maintain an appropriate polishing contact pressure. A tube 314 opposite polishing head 308 above polishing pad 304 dispenses and evenly saturates the pad with an appropriate cleaning agent 316, typically a slurry.

In employing conventional CMP techniques and apparatus such as that depicted in Fig. 3, it is difficult to obtain in a uniformly planarized surface at a high removal rate of material undergoing planarization, particularly of a high density wiring pattern with interwire spacings of less than about 0.5 microns covered with a dielectric material.

The problem of achieving uniform planarization at a high removal rate of material utilizing conventional CMP techniques and apparatus is recognized in the semiconductor industry. Previous attempts to solve this problem focus upon improvements in the consumable materials employed during CMP, such as the polishing pad and cleaning agent, or improvements in the hardware itself, such as the CMP apparatus. These prior efforts have proved less than satisfactory.

### Disclosure of the Invention

An object of the present invention is a CMP method for uniformly planarizing a surface on a wafer at a high removal rate of material.

Additional advantages of the invention will be set forth in part in the description which follows and in part will become apparent to those having ordinary skill in the art upon examination of the following or may be learned from practice of the invention. The advantages of the invention may be realized and attained as particularly pointed out in the appended claims.

According to the present invention, there is provided a method of manufacturing a semiconductor device wherein a surface on a wafer is planarized, comprising: placing the wafer to be planarized on a polishing pad; applying a cleaning agent to the polishing pad; chemical-mechanical polishing the surface to effect planarization while applying a first pressure to the wafer; and intermittently reducing the first pressure to a second pressure a plurality of times during the course of chemical-mechanical polishing, whereby the pulsing pressure thereby created prevents starvation areas having insufficient cleaning agent on the wafer.

Additional advantages of the present invention will become readily apparent to those skilled in this art from the following detailed description, wherein only the preferred embodiment of the invention is shown and described, simply by way of illustration of the best mode contemplated for carrying out the invention. As will be realized, the invention is capable of other and different embodiments, and its several details are capable of modifications in various obvious respects, all without departing from the invention. Accordingly, the drawings and description are to be regarded as illustrative in nature, and not as restrictive.

### Brief Description of Drawings

Figure 1 illustrate a layer of material deposited on a patterned material.

Figure 2 illustrates the planarized deposited layer of Figure 1.

Figure 3 schematically illustrates a typical chemical-mechanical polishing machine.

### Description of the Invention

The present invention addresses the limitations of conventional CMP technology in achieving uniformly planarized surfaces of materials, particularly dielectric materials, at high removal rates. The inability of conventional CMP technology to achieve high polishing rates constitutes a serious economic impediment. Time consuming CMP decreases production throughput, consumes man hours and exhausts large amounts of cleaning agent and other consumable materials. The lack of a uniformly planarized surface adversely affects the reliability of the resulting semiconductor device, particularly in devices comprising multi-level vias wherein the upper vias would be overetched to insure complete etching at the lower levels.

The present invention addresses and solves such limitations of conventional CMP technology, i.e., methodology and apparatus, by selecting an appropriate initial pressure applied to wafer undergoing CMP and intermittently reducing the initial pressure to a second pressure a plurality of times during the course of CMP processing. I discovered that during the course of CMP processing, the surface to be polished in contact with the polishing pad becomes depleted in cleaning agent, which adversely affects the polishing rate and uniformity of the CMP operation, since incomplete polishing occurs in depleted areas, as toward the center of the wafer. In accordance with my invention, the initial pressure applied to the wafer undergoing CMP is intermittently reduced creating a pulsing pressure, thereby enabling the cleaning agent, which is normally continuously applied to the polishing pad, to continuously reach all portions of the surface of the wafer undergoing polishing throughout the entire CMP operation. Thus, the periodic reduction of pressure applied to the wafer during CMP processing eliminates the negative impact of starvation areas, i.e., areas which do not have a sufficient amount of cleaning agent.

The present invention can be practiced employing otherwise conventional CMP technology, i.e., techniques and apparatus. For example, the CMP apparatus disclosed in the previously mentioned ***Gill, Jr****.* or ***Walsh*** patents can be employed in the practice of the present invention. A commercially available CMP apparatus which can be employed in the present invention is Model 372 Polish and manufactured by Westex Systems, Inc., of Phoenix, Arizona or Strasbaug, San Luis Opisbo, California Model 6DFSP form. The polishing pad employed in the claimed invention can be any of those which are conventionally employed in CMP, such as those comprising a cellular polyurethane pad, preferably about 50 mills thick. The cleaning agent employed in the claimed invention can be any of those conventionally employed in CMP processing. In a preferred embodiment, a slurry, most preferably a slurry comprising potassium hydroxide and particulate silica, is employed.

In practicing the present invention, an optimum initial pressure is selected to obtain effective removal of material at an economically desirable high rate of speed, typically between about 6 and about 9 psi. In accordance with present invention, the second or reduced pressure is generally less than about 2 psi, preferably less than about 1 psi, preferably about 0 psi. The polishing speed or rotations of the polishing pad is generally between about 20 and about 50 RPM.

The improved CMP technique of the present invention can be employed to planarize various types of surfaces on a wafer, including conductive and insulating materials, such as oxides, tetraethyl orthosilicate, also referred to as tetraethoxysilane (TEOS), nitrides, polysilicon, single crystalline silicon, amorphous silicon, and mixtures thereof. Preferably, a dielectric layer, such as TEOS, is deposited on a conductive pattern and planarized in accordance with the claimed invention in a manner similar to that generally schematically illustrated in Figs. 1 and 2. The substrate of the wafer containing the conductive or non-conductive material is generally a semiconductor material, such as silicon.

In conducting the present inventive method, the first pressure is intermittently reduced to the second pressure during the course of CMP. The frequency of reducing the initial pressure depends upon each particular CMP operation, e.g., the particular CMP apparatus, speed of polishing, materials undergoing planarization and cleaning agent. Preferably, the first pressure is reduced to the second pressure about every 1 to 15 seconds, preferably about every 1 to 10 seconds, most preferably about every 1 to 5 seconds. In a most preferred embodiment, the first pressure is intermittently reduced to the second pressure about every 1 to 3 seconds.

By the present invention, the speed and uniformity of planarization effected by conventional CMP technology is greatly improved by virtue intermittently reducing the pressure applied to the wafer undergoing planarization from an optimum initial pressure, preferably to about 0 psi. The inventive pulse CMP technique is applicable to a wide variety of situations which require planarization during the course of manufacturing a semiconductor device.

Only the preferred embodiment of the invention and but a few examples of its versatility are shown and described in the present disclosure. It is to be understood that the invention is capable of use in various other combinations and environments and is capable of changes or modifications within the scope of the inventive concept as expressed in the following claims.

## Claims

1. A method of manufacturing a semiconductor device wherein a surface on a wafer (306) is planarized, comprising:
placing the wafer (306) to be planarized on a polishing pad (304);
applying a cleaning agent to the polishing pad (304);
chemical-mechanical polishing the surface to effect planarization while applying a first pressure to the wafer (306); characterized by
intermittently reducing the first pressure to a second pressure a plurality of times during the course of chemical-mechanical polishing, whereby the pulsing pressure thereby created prevents starvation areas having insufficient cleaning agent on the wafer (306).

2. A method as claimed in claim 1, wherein the first pressure is 41 to 62 kPa (6 to 9 psi), and the second pressure is less than 13.8 kPa (2 psi).

3. A method as claimed in claim 2, wherein the second pressure is less than 6.9 kPa (1 psi).

4. A method as claimed in claim 3, wherein the second pressure is 0 kPa (0 psi).

5. A method as claimed in any preceding claim, wherein the surface of the wafer (306) comprises an insulating material.

6. A method as claimed in claim 5, wherein the insulating material is selected from the group consisting of an oxide, nitride, and mixtures thereof.

7. A method as claimed in claim 6, wherein the insulating material is TEOS.

8. A method as claimed in claim 6, wherein the insulating material is silicon dioxide.

9. A method as claimed in any preceding claim, wherein the surface of the wafer (306) comprises a material selected from the group consisting of an oxide, nitride, polysilicon, single crystalline silicon, amorphous silicon, and mixtures thereof.

10. A method as claimed in any preceding claim, wherein the substrate comprises silicon.

11. A method as claimed in any preceding claim, wherein the first pressure is intermittently reduced to the second pressure about every 1 to 15 seconds during chemical-mechanical polishing.

12. A method as claimed in claim 11, wherein the first pressure is intermittently reduced to the second pressure about every 1 to 10 seconds.

13. A method as claimed in claim 12, wherein the first pressure is intermittently reduced to the second pressure about every 1 to 5 seconds.

14. A method as claimed in claim 13, wherein the first pressure is intermittently reduced to the second pressure about every 1 to 3 seconds.

15. A method as claimed in any preceding claim, wherein the polishing pad (304) comprises a fibrous polymer.

16. A method as claimed in any preceding claim, wherein the cleaning agent comprises a slurry.

17. A method as claimed in claim 16, wherein the slurry comprises potassium hydroxide and particular silica.

## Patentansprüche

1. Verfahren zum Herstellen einer Halbleitervorrichtung, bei dem eine Oberfläche auf einem Wafer (306) geglättet wird, mit folgenden Schritten:
Plazieren des zu glättenden Wafers (306) auf eine Polierauflage (304);
Auftragen eines Reinigungsmittels auf die Pollerauflage (304);
chemisch-mechanisches Polieren der Oberfläche zwecks Glättung, während ein erster Druck auf den Wafer (306) aufgebracht wird;
**gekennzeichnet durch**
mehrmaliges intermittierendes Reduzieren des ersten Drucks auf einen zweiten Druck während des chemisch-mechanischen Polierens, so daß durch den dadurch erzeugten Impulsdruck verhindert wird, daß auf dem Wafer (306) Bereiche mit einer unzureichenden Menge an Reinigungsmittel verbleiben.

2. Verfahren nach Anspruch 1, bei dem der erste Druck 41 bis 62 kPa (6 bis 9 psi) und der zweite Druck weniger als 13,8 kPa (2 psi) beträgt.

3. Verfahren nach Anspruch 2, bei dem der zweite Druck weniger als 6,9 kPa (1 psi) beträgt.

4. Verfahren nach Anspruch 3, bei dem der zweite Druck 0 kPa (0 psi) beträgt.

5. Verfahren nach einem der vorhergehenden Ansprüche, bei dem die Oberfläche des Wafers (306) ein Isoliermaterial aufweist.

6. Verfahren nach Anspruch 5, bei dem das Isoliermaterial aus der Gruppe von Oxid, Nitrid und Mischungen daraus ausgewählt wird.

7. Verfahren nach Anspruch 6, bei dem das Isoliermaterial TEOS ist.

8. Verfahren nach Anspruch 6, bei dem das Isoliermaterial Siliciumdioxid ist.

9. Verfahren nach einem der vorhergehenden Ansprüche, bei dem die Oberfläche des Wafers (306) ein aus der Gruppe von Oxid, Nitrid, Polysilicium, einzelkristallinem Silicium, amorphem Silicium und Mischungen daraus ausgewähltes Material aufweist.

10. Verfahren nach einem der vorhergehenden Ansprüche, bei dem das Substrat Silicium enthält.

11. Verfahren nach einem der vorhergehenden Ansprüche, bei dem der erste Druck während des chemisch-mechanischen Polierens intermittierend ungefähr alle 1 bis 15 Sekunden auf den zweiten Druck reduziert wird.

12. Verfahren nach Anspruch 11, bei dem der erste Druck Intermittierend ungefähr alle 1 bis 10 Sekunden auf den zweiten Druck reduziert wird.

13. Verfahren nach Anspruch 12, bei dem der erste Druck Intermittierend ungefähr alle 1 bis 5 Sekunden auf den zweiten Druck reduziert wird.

14. Verfahren nach Anspruch 13, bei dem der erste Druck Intermittierend ungefähr alle 1 bis 3 Sekunden auf den zweiten Druck reduziert wird.

15. Verfahren nach einem der vorhergehenden Ansprüche, bei dem das Polierkissen (304) Polymerfasern aufweist.

16. Verfahren nach einem der vorhergehenden Ansprüche, bei dem das Reinigungsmittel einen Schlamm enthält.

17. Verfahren nach Anspruch 16, bei dem der Schlamm Kallumhydroxid und partikuläre Silica enthält.

## Revendications

1. Procédé de fabrication d'un dispositif à semi-conducteur dans lequel une surface d'une plaquette (306) est aplanie, consistant à :
placer la plaquette (306) à aplanir sur un disque de polissage (304) ;
appliquer un agent nettoyant sur le disque de polissage (304) ;
effectuer un polissage chimique-mécanique de la surface pour réaliser l'aplanissement tout en appliquant une première pression sur la plaquette (306) ; caractérisé en ce que
la première pression est réduite par intermittence afin d'exercer plusieurs fois une seconde pression au cours du polissage chimique-mécanique, de sorte que la pression à impulsion générée de ce fait empêche la formation de zones de manque présentant une quantité insuffisante d'agent nettoyant sur la plaquette (306).

2. Procédé selon la revendication 1, dans lequel la première pression est de 41 à 62 kPa (6 à 9 psi) et la seconde pression est inférieure à 13,8 kPa (2 psi).

3. Procédé selon la revendication 2, dans lequel la seconde pression est inférieure à 6,9 kPa (1 psi).

4. Procédé selon la revendication 3, dans lequel la seconde pression est 0 kPa (0 psi).

5. Procédé selon l'une quelconque des revendications précédentes, dans lequel la surface de la plaquette (306) comprend un matériau isolant.

6. Procédé selon la revendication 5, dans lequel le matériau isolant est sélectionné dans le groupe constitué d'un oxyde, d'un nitrure, et de leurs mélanges.

7. Procédé selon la revendication 6, dans lequel le matériau isolant est le TEOS (tétraéthoxysilane).

8. Procédé selon la revendication 6, dans lequel le matériau isolant est de l'oxyde de silicium.

9. Procédé selon l'une quelconque des revendications précédentes, dans lequel la surface de la plaquette (306) comprend un matériau sélectionné dans le groupe constitué d'un oxyde, d'un nitrure, de polysilicium, de silicium monocristallin, de silicium amorphe et de leurs mélanges.

10. Procédé selon l'une quelconque des revendications précédentes dans lequel le substrat comprend du silicium.

11. Procédé selon l'une quelconque des revendications précédentes, dans lequel la première pression est réduite par intermittence à la seconde pression toutes les 1 à 15 secondes environ pendant le polissage chimique-mécanique.

12. Procédé selon la revendication 11, dans lequel la première pression est réduite par intermittence à la seconde pression toutes les 1 à 10 secondes environ.

13. Procédé selon la revendication 12, dans lequel la première pression est réduite par intermittence à la seconde pression toutes les 1 à 5 secondes environ.

14. Procédé selon la revendication 13, dans lequel la première pression est réduite par intermittence à la seconde pression toutes les 1 à 3 secondes environ.

15. Procédé selon l'une quelconque des revendications précédentes, dans lequel le disque de polissage (304) comporte un polymère à fibres.

16. Procédé selon l'une quelconque des revendications précédentes, dans lequel l'agent nettoyant comporte une suspension.

17. Procédé selon la revendication 16, dans lequel la suspension comporte de l'hydroxyde de potassium et de la silice spéciale.
